# EUROPEAN PATENT APPLICATION

(11) **EP 3 536 546 A1**
(43) Date of publication of application: **11.09.2019**
(21) Application number: 19154034.3
(22) Date of filing: 28.01.2019
(51) Int. Cl.: B60L 53/80, B60L 53/68, B60L 53/67

(54) **ELECTRIC CARRIER SYSTEM AND METHOD FOR TRACKING LOST BATTERY**

(30) Priority: 06.03.2018 TW 10707383
(71) Applicant: Kwang Yang Motor Co., Ltd., Kaohsiung City 80794 (TW)
(72) Inventor: LIN, Chen-Sheng, 80794 Kaohsiung (TW); LI, Yi-Lin, 80794 Kaohsiung (TW); CHEN, Yuh-Rey, 11501 Taipei City (TW); CHUANG, Po-Yu, 11501 Taipei City (TW); LIN, Jen-Chiun, 11501 Taipei City (TW); LIU, Te-Chuan, 11501 Taipei City (TW)
(74) Representative: Brevalex

(57) **Abstract**

A method for tracking a lost battery is to be implemented by an electric carrier system, and includes the following steps: recording a loss report that includes a concerned battery identifier which corresponds to a concerned battery; detecting a detected battery identifier of a detected battery, and obtaining location information that relates to where the detected battery is located; determining whether the detected battery identifier matches the concerned battery identifier; and recording the location information when it is determined that the detected battery identifier matches the concerned battery identifier.

## Description

The disclosure relates to an electric carrier system and a method for tracking a lost battery.

A battery of an electric vehicle (EV) having the design of battery swapping is usually costly, and is prone to theft due to the nature of battery swapping. A conventional approach of looking for a lost battery based on security cameras is inefficient and labor intensive.

Therefore, an object of the disclosure is to provide an electric carrier system and a method for tracking a lost battery that can alleviate at least one of the drawbacks of the prior art.

According to one aspect of the disclosure, the method for tracking a lost battery is to be implemented by an electric carrier system. The electric carrier system stores plural sets of battery data, and a plurality of reference battery identifiers which correspond respectively to the plural sets of battery data. The method includes following steps:
(A) recording, by the electric carrier system, a loss report that includes a concerned battery identifier which is one of the reference battery identifiers and which corresponds to a concerned battery, and a loss flag which corresponds to the concerned battery identifier and which indicates that the concerned battery is lost;
(B) by the electric carrier system, detecting a detected battery identifier of a detected battery, and obtaining location information that relates to where the detected battery is located;
(C) determining, by the electric carrier system, whether the detected battery identifier matches the concerned battery identifier to which the loss flag corresponds; and
(D) recording, by the electric carrier system, the location information when it is determined that the detected battery identifier matches the concerned battery identifier.

According to another aspect of the disclosure, the electric carrier system includes at least one charging station and a server. Said at least one charging station is configured to detect a detected battery identifier of a detected battery, and to transmit the detected battery identifier and location information that relates to where said at least one charging station is located. The server is communicable with said at least one charging station, and is configured to: receive the detected battery identifier and the location information transmitted by said at least one charging station; to store plural sets of battery data and a plurality of reference battery identifiers which correspond respectively to the plural sets of battery data; to record a loss report that includes a concerned battery identifier which is one of the reference battery identifiers and which corresponds to a concerned battery, and a lost flag which corresponds to the concerned battery identifier and which indicates that the concerned battery is lost; to determine whether the detected battery identifier matches the concerned battery identifier to which the loss flag corresponds; and to record the location information when it is determined that the detected battery identifier matches the concerned battery identifier.

According to still another aspect of the disclosure, the electric carrier system includes at least one electric carrier device and a server. Said at least one electric carrier device is configured to detect a detected battery identifier of a detected battery installed on said at least one electric carrier device, and to transmit location information that relates to where said at least one electric carrier device is located. The server is communicable with said at least one electric carrier device, and is configured to: receive the detected battery identifier and the location information transmitted by said at least one electric carrier device; to store plural sets of battery data and a plurality of reference battery identifiers which correspond respectively to the plural sets of battery data; to record a loss report that includes a concerned battery identifier which is one of the reference battery identifiers and which corresponds to a concerned battery, and a loss flag which corresponds to the concerned battery identifier and which indicates that the concerned battery is lost; to determine whether the detected battery identifier matches the concerned battery identifier to which the loss flag corresponds; and to record the location information when it is determined that the detected battery identifier matches the concerned battery identifier.

Other features and advantages of the disclosure will become apparent in the following detailed description of the embodiments with reference to the accompanying drawings, of which:
Figure 1 is a block diagram illustrating a first embodiment of an electric carrier system according to the disclosure;
Figure 2 is a flow chart illustrating a first embodiment of a method for tracking a lost battery according to the disclosure;
Figure 3 is a flow chart illustrating an embodiment of sub-steps of detecting a detected battery identifier in the method for tracking a lost battery according to the disclosure;
Figure 4 is a block diagram illustrating a second embodiment of the electric carrier system according to the disclosure;
Figure 5 is a flow chart illustrating a second embodiment of the method for tracking a lost battery according to the disclosure; and
Figure 6 is a flow chart illustrating another embodiment of sub-steps of detecting a detected battery identifier in the method for tracking a lost battery according to the disclosure.

Before the disclosure is described in greater detail, it should be noted that where considered appropriate, reference numerals or terminal portions of reference numerals have been repeated among the figures to indicate corresponding or analogous elements, which may optionally have similar characteristics.

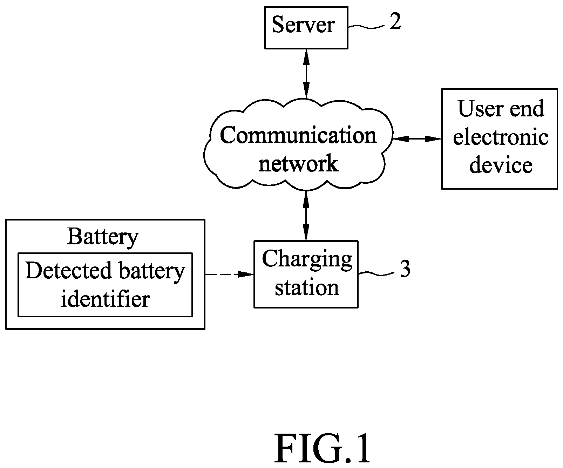

Referring to Figure 1, a first embodiment of an electric carrier system according to the disclosure is illustrated. The electric carrier system includes at least one charging station 3 and a server 2. Operation of the electric carrier system is assisted by customized mobile application software (e.g., an application program, APP) that is developed by a vehicle manufacturer.

Each charging station 3 is configured to detect a battery identifier of a detected battery (hereinafter also referred to as "detected battery identifier"), and to transmit the detected battery identifier and location information that relates to where the detected battery is located. In this embodiment, each charging station 3 is implemented to be a battery swapping/switching station, but implementation of the charging station(s) 3 is not limited to the disclosure herein and may vary in other embodiments.

The server 2 is communicable with said at least one charging station 3 via a communication network, such as the Internet. In this embodiment, the server 2 is implemented to be a personal computer or a cloud server that is capable of establishing a communication channel for data transmission with the charging station(s) 3 by means of WiFi technologies or Bluetooth technologies. However, implementation of the server 2 is not limited to the disclosure herein and may vary in other embodiments.

The server 2 is configured to store plural sets of battery data and a plurality of reference battery identifiers which correspond respectively to the plural sets of battery data. The server 2 is configured to record a loss report that includes a concerned battery identifier which is one of the reference battery identifiers and which corresponds to a concerned battery, and a lost flag which corresponds to the concerned battery identifier and which indicates that the concerned battery is lost. The server 2 is configured to receive the detected battery identifier and the location information transmitted by the charging station 3, and to determine whether the detected battery identifier matches the concerned battery identifier to which the loss flag corresponds, and to record the location information when it is determined that the detected battery identifier matches the concerned battery identifier.

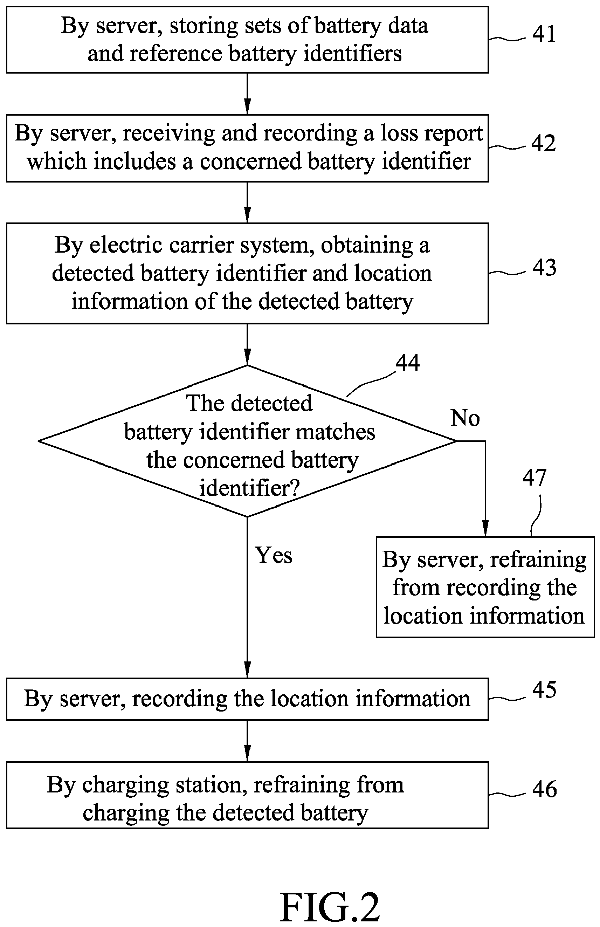

Referring to Figure 2, a first embodiment of a method for tracking a lost battery according to the disclosure is illustrated. The first embodiment of the method is to be implemented by the first embodiment of the electric carrier system that is previously described. The method includes the following steps 41 to 47.

In step 41, the server 2 of the electric carrier system stores the plural sets of battery data, and the plurality of reference battery identifiers corresponding respectively to the plural sets of battery data.

In step 42, when the server 2 receives a loss report from a user of a concerned battery, i.e., the loss report transmitted by a user end electronic device (e.g., a mobile device that is installed with the customized mobile application software) of the user who realized that the concerned battery is missing, the server 2 of the electric carrier system records the loss report. The loss report includes a concerned battery identifier which is one of the reference battery identifiers and which corresponds to the concerned battery, and a loss flag which corresponds to the concerned battery identifier and which indicates that the concerned battery is lost.

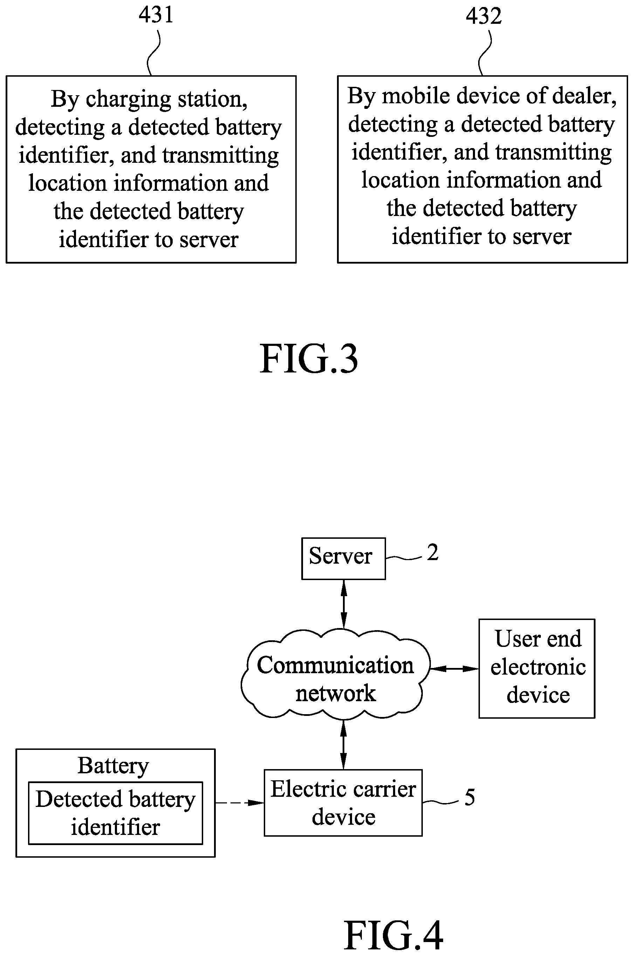

In step 43, one of the at least one charging station 3 of the electric carrier system detects the detected battery identifier of the detected battery, and obtains the location information that relates to where the detected battery is located, i.e., where said one of the at least one charging station 3 is located. Specifically speaking, step 43 includes the following sub-step 431 or sub-step 432 as shown in Figure 3.

In sub-step 431, one of said at least one charging station 3 detects the detected battery identifier of the detected battery through a near-field communication (NFC) module based on NFC protocols, and transmits the location information and the detected battery identifier to the server 2. In one embodiment, said one of said at least one charging station 3 transmits a charging station identifier instead of the location information to the server 2, and the server 2 determines a location of said one of said at least one of charging station 3 based on the charging station identifier.

Alternatively, in sub-step 432, if said one of the at least one charging station 3 is located at a dealer's end, a mobile device of the dealer that is installed with the customized mobile application software may be used to read the detected battery identifier via its NFC module based on NFC protocols, and to upload the detected battery identifier and position information associated with where the mobile device of the dealer is located to the server 2. In one embodiment, the mobile device of the dealer transmits a mobile device identifier instead of the position information to the server 2, and the server 2 determines where the mobile device of the dealer is located based on the mobile device identifier.

It should be noted that sub-steps 431 and 432 may be performed individually for different scenarios.

Referring back to Figure 2, in step 44, the server 2 of the electric carrier system determines whether the detected battery identifier matches the concerned battery identifier to which the loss flag corresponds. When it is determined that the detected battery identifier matches the concerned battery identifier, the flow proceeds to step 45. Otherwise, the flow proceeds to step 47.

In step 45, the server 2 of the electric carrier system records the location information. That is to say, the detected battery is determined to be the concerned battery that has been lost, and a geographic location of said one of the at least one charging station 3 where the detected battery is detected and located is recorded. In this way, the concerned battery that was reported missing may be found without requiring many labor resources.

In step 46, the server 2 of the electric carrier system transmits a lock instruction to said one of the at least one charging station 3 in order to enable said one of the at least one charging station 3 to refrain from charging the detected battery. Thereafter, said one of the at least one charging station 3, according to the lock instruction, outputs a warning (e.g., by displaying warning light) and refrains from charging the detected battery.

In step 47, the server 2 of the electric carrier system does not record the location information. It should be noted that in some embodiments, the server 2 of the electric carrier system still records the location information but does not associate the location information with the concerned battery that is lost.

Referring to Figure 4, a second embodiment of the electric carrier system according to the disclosure is illustrated. The electric carrier system includes at least one electric carrier device 5 and a server 2.

In this embodiment, each electric carrier device 5 is implemented to be an electric vehicle (EV) that is supplied with electrical energy by a battery, but implementation of the electric carrier device(s) 5 is not limited to the disclosure herein and may vary in other embodiments.

Each electric carrier device 5 is configured to store a set of specific battery data and a specific battery identifier that corresponds to the set of specific battery data. Each electric carrier device 5 is configured to detect a battery identifier of a battery installed on the electric carrier device 5 (hereinafter also referred to as a "detected battery identifier" of a "detected battery"). Each electric carrier device 5 is configured to transmit location information that relates to where the electric carrier device 5 is located to the server 2.

The server 2 is implemented to be a personal computer or a cloud server, is communicable with the electric carrier device(s) 5 via the network, and is capable of establishing a communication channel for data transmission with at least one electric carrier device 5 by means of WiFi technologies or Bluetooth technologies. The server 2 is configured to store plural sets of battery data and a plurality of reference battery identifiers which correspond respectively to the plural sets of battery data, and to record a loss report. The lost report includes a concerned battery identifier which is one of the reference battery identifiers and which corresponds to a concerned battery, and a loss flag which corresponds to the concerned battery identifier and which indicates that the concerned battery is lost. The server 2 is configured to receive the detected battery identifier and the location information transmitted by any electric carrier device 5, to determine whether the detected battery identifier matches the concerned battery identifier to which the loss flag corresponds, and to record the location information when it is determined that the detected battery identifier matches the concerned battery identifier.

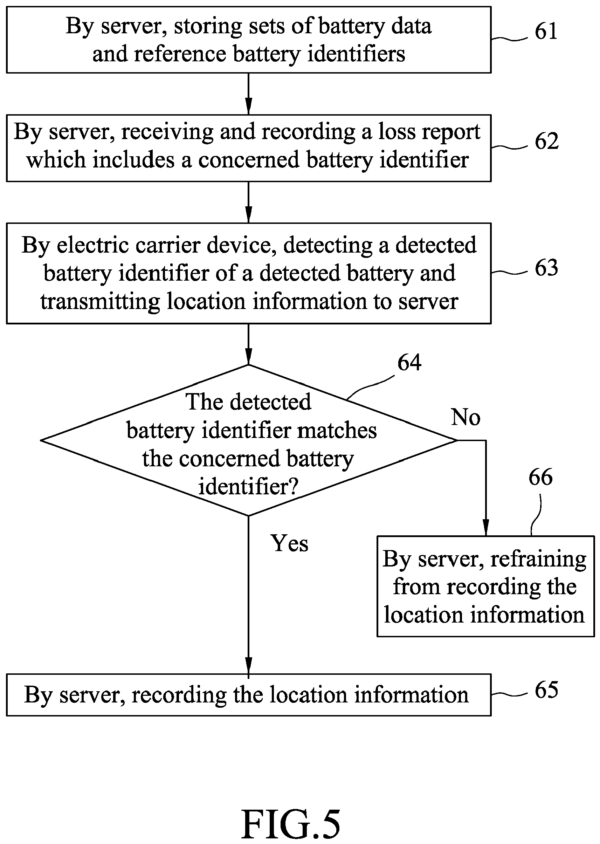

Referring to Figure 5, a second embodiment of the method for tracking a lost battery according to the disclosure is illustrated. The second embodiment of the method is to be implemented by the second embodiment of the electric carrier system that is previously described. The method includes the following steps 61 to 65.

In step 61, the server 2 stores the plural sets of battery data and the plurality of reference battery identifiers which correspond respectively to the plural sets of battery data.

In step 62, the server 2 records a loss report from a user of a concerned battery, i.e., the loss report transmitted by a user end electronic device (e.g., a mobile device that is installed with the customized mobile application software) of the user who realized that the concerned battery is missing. The lost report includes a concerned battery identifier which is one of the reference battery identifiers and which corresponds to the concerned battery, and a loss flag which corresponds to the concerned battery identifier and which indicates that the concerned battery is lost.

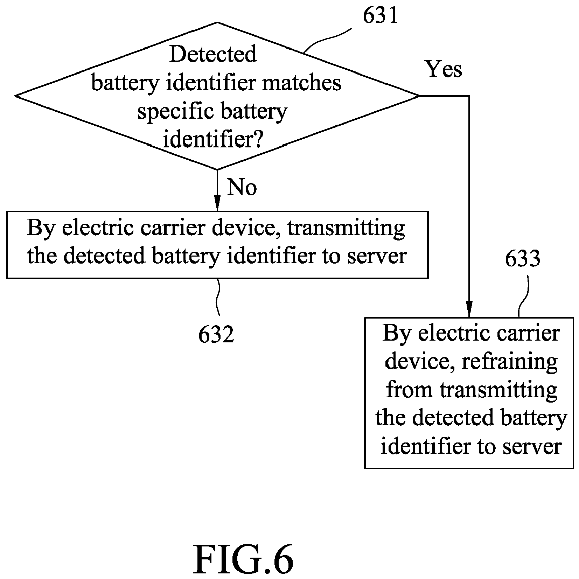

Step 63 is performed by each of said at least one electric carrier device 5 when the individual electric carrier device 5 starts up. In step 63, when starting up, the electric carrier device 5 detects a battery identifier of a battery installed on the electric carrier device 5, and at the same time, transmits the location information that relates to where the electric carrier device 5 is currently located to the server 2. Specifically speaking, step 63 includes the following sub-steps 631 to 633 as shown in Figure 6.

In sub-step 631, when starting up, the electric carrier device 5 detects the battery identifier of the battery installed thereon, and determines whether the detected battery identifier matches the specific battery identifier stored in the electric carrier device 5. At the same time, the electric carrier device 5 transmits the location information that relates to where the electric carrier device 5 is currently located to the server 2.

When it is determined by the electric carrier device 5 in sub-step 631 that the detected battery identifier does not match the specific battery identifier, the flow proceeds to sub-step 632, where the electric carrier device 5 transmits the detected battery identifier to the server 2. In other words, the electric carrier device 5 transmits the detected battery identifier to the server 2 when the battery installed on the electric carrier device 5 is not a legitimate battery for the electric carrier device 5.

When it is determined by the electric carrier device 5 in sub-step 631 that the detected battery identifier matches the specific battery identifier, the flow proceeds to sub-step 633, in which the electric carrier device 5 does not transmit the detected battery identifier to the server 2.

Referring back to Figure 5, in step 64, the server 2 determines whether the detected battery identifier, which is obtained from one of the at least one electric carrier device 5, matches the concerned battery identifier to which the loss flag corresponds.

In step 65, the server 2 records the location information obtained from said one of the at least one electric carrier device 5 when it is determined that the detected battery identifier matches the concerned battery identifier. That is to say, the detected battery is determined to be the concerned battery that was lost, and a geographic location where the detected battery is located is recorded. In this way, the concerned battery that is reported missing may be found without requiring many labor resources.

In step 66, the server 2 does not record the location information when it is determined that the detected battery identifier does not match the concerned battery identifier. It should be noted that in one embodiment, the server 2 of the electric carrier system still records the location information but does not associate the location information with the concerned battery that is lost.

In summary, the methods according to the disclosure utilize the electric carrier system to record the loss report that includes a concerned battery identifier of a lost battery, to obtain a detected battery identifier of a detected battery and location information of the detected battery, to determine whether the detected battery identifier matches the concerned battery identifier, and to record the location information when it is determined that the detected battery identifier matches the concerned battery identifier. Therefore, labor cost related to looking for the lost battery may be reduced.

Moreover, by storing a concerned battery identifier of a lost battery on the server, and by comparing concerned battery identifiers with battery identifiers of batteries that are in use, the electric carrier system according to the disclosure is capable of rapidly determining whether one of the batteries that are in use is a lost battery. Additionally, when it is determined by the server that one of the batteries that are in use is the lost battery, the server instantly records location information related to where the lost battery is located. Therefore, only a small amount of labor is required to look for the lost battery when the electric carrier system according to the disclosure is utilized.

In the description above, for the purposes of explanation, numerous specific details have been set forth in order to provide a thorough understanding of the embodiments. It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects, and that one or more features or specific details from one embodiment may be practiced together with one or more features or specific details from another embodiment, where appropriate, in the practice of the disclosure.

## Claims

1. A method for tracking a lost battery, to be implemented by an electric carrier system, the electric carrier system storing plural sets of battery data, and a plurality of reference battery identifiers which correspond respectively to the plural sets of battery data, the method **characterized by** following steps:
(A) recording, by the electric carrier system, a loss report that includes a concerned battery identifier which is one of the reference battery identifiers and which corresponds to a concerned battery, and a loss flag which corresponds to the concerned battery identifier and which indicates that the concerned battery is lost;
(B) by the electric carrier system, detecting a detected battery identifier of a detected battery, and obtaining location information that relates to where the detected battery is located;
(C) determining, by the electric carrier system, whether the detected battery identifier matches the concerned battery identifier to which the loss flag corresponds; and
(D) recording, by the electric carrier system, the location information when it is determined that the detected battery identifier matches the concerned battery identifier.

2. The method as claimed in claim 1, the electric carrier system further including a server (2) and at least one charging station (3) which is communicable with the server (2), the server (2) storing the plural sets of battery data and the plurality of reference battery identifiers, the method **characterized in that** step (B) includes a following sub-step:
(B-1) by one of the at least one charging station (3), detecting the detected battery identifier of the detected battery and transmitting the location information and the detected battery identifier to the server (2).

3. The method as claimed in claim 2, subsequent to step (D), further **characterized by**:
by the electric carrier system, executing a lock instruction which enables said one of the at least one charging station (3) to refrain from charging the detected battery.

4. The method as claimed in claim 1, the electric carrier system including a server (2) and at least one electric carrier device (5) which is communicable with the server (2), each of said at least one electric carrier device (5) storing a set of specific battery data and a specific battery identifier that corresponds to the set of specific battery data, the method **characterized in that** step (B) includes following sub-steps:
(B-1') by one of the at least one electric carrier device (5), detecting the detected battery identifier of the detected battery installed on said one of the at least one electric carrier device (5), determining whether the detected battery identifier matches the specific battery identifier, and transmitting the location information to the server (2); and
(B-2') by said one of the at least one electric carrier device (5), transmitting the detected battery identifier to the server (2) when it is determined that the detected battery identifier does not match the specific battery identifier.

5. An electric carrier system **characterized by**:
at least one charging station (3) configured to detect a detected battery identifier of a detected battery, and to transmit the detected battery identifier and location information that relates to where said at least one charging station (3) is located; and
a server (2) communicable with said at least one charging station (3), and configured to
receive the detected battery identifier and the location information transmitted by said at least one charging station (3),
store plural sets of battery data and a plurality of reference battery identifiers which correspond respectively to the plural sets of battery data,
record a loss report that includes a concerned battery identifier which is one of the reference battery identifiers and which corresponds to a concerned battery, and a lost flag which corresponds to the concerned battery identifier and which indicates that the concerned battery is lost,
determine whether the detected battery identifier matches the concerned battery identifier to which the loss flag corresponds, and
record the location information when it is determined that the detected battery identifier matches the concerned battery identifier.

6. An electric carrier system **characterized by**:
at least one electric carrier device (5) which is configured to detect a detected battery identifier of a detected battery installed on said at least one electric carrier device, and to transmit location information that relates to where said at least one electric carrier device (5) is located; and
a server (2) communicable with said at least one electric carrier device (5), and configured to
receive the detected battery identifier and the location information transmitted by said at least one electric carrier device (5),
store plural sets of battery data and a plurality of reference battery identifiers which correspond respectively to the plural sets of battery data,
record a loss report that includes a concerned battery identifier which is one of the reference battery identifiers and which corresponds to a concerned battery, and a loss flag which corresponds to the concerned battery identifier and which indicates that the concerned battery is lost,
determine whether the detected battery identifier matches the concerned battery identifier to which the loss flag corresponds, and
record the location information when it is determined that the detected battery identifier matches the concerned battery identifier.
